Europäisches Patentamt

**European Patent Office**

Office européen des brevets

(19)

(11) Publication number: **0 111 307**
A2

(12) # EUROPEAN PATENT APPLICATION

(21) Application number: **83112313.8**

(22) Date of filing: **07.12.83**

(51) Int. Cl.³: **H 01 L 27/10**
**H 01 L 27/06, H 01 L 21/82**
**//G11C11/40**

(30) Priority: **13.12.82 JP 216825/82**

(43) Date of publication of application:
**20.06.84 Bulletin 84/25**

(84) Designated Contracting States:
**DE FR GB NL**

(71) Applicant: **HITACHI, LTD.**
**6, Kanda Surugadai 4-chome Chiyoda-ku**
**Tokyo 100(JP)**

(72) Inventor: **Hanamura, Shoji**
**3-1-3, Higashi-koigakubo**
**Kokubunji-shi Tokyo(JP)**

(72) Inventor: **Minato, Osamu**
**2196-660, Hirai Hinodemachi**
**Nishitama-gun Tokyo(JP)**

(72) Inventor: **Sasaki, Toshio**
**1-48-18, Akatsuki-cho**
**Hachioji-shi Tokyo(JP)**

(72) Inventor: **Yamamoto, Syuuichi**
**3-1-3, Higashi-koigakubo**
**Kokubunji-shi Tokyo(JP)**

(72) Inventor: **Masuhara, Toshiaki**
**2196-278, Hirai Hinodemachi**
**Nishitama-gun Tokyo(JP)**

(74) Representative: **Strehl, Peter et al,**
**Dipl.-Ing. P. Strehl Dr. U. Schübel-Hopf Dr. R. Schulz**
**Patentanwälte Widenmayerstrasse 17 Postfach 22 03 45**
**D-8000 München 22(DE)**

(54) **Semiconductor integrated circuit having a buried resistor.**

(57) A semiconductor integrated circuit includes a p-type well region (22) formed on an n-type semiconductor substrate (21). A hole extends from the surface of said p-type well region (22) to the substrate (21) and an intrinsic or lowly doped semiconductor (27) is buried through an insulating film (26) in said hole. This semiconductor (27) is used as a resistor.

*FIG. 4*

SEMICONDUCTOR INTEGRATED CIRCUIT HAVING A BURIED
RESISTOR

BACKGROUND OF THE INVENTION

Field of the Invention

The present invention relates to a semiconductor integrated circuit and, more particularly, to a semiconductor integrated circuit having a buried resistor.

Description of the Prior Art

In a semiconductor integrated circuit, a variety of elements such as transistors or resistors are formed on the semiconductor body, and such resistors are frequently used as load elements.

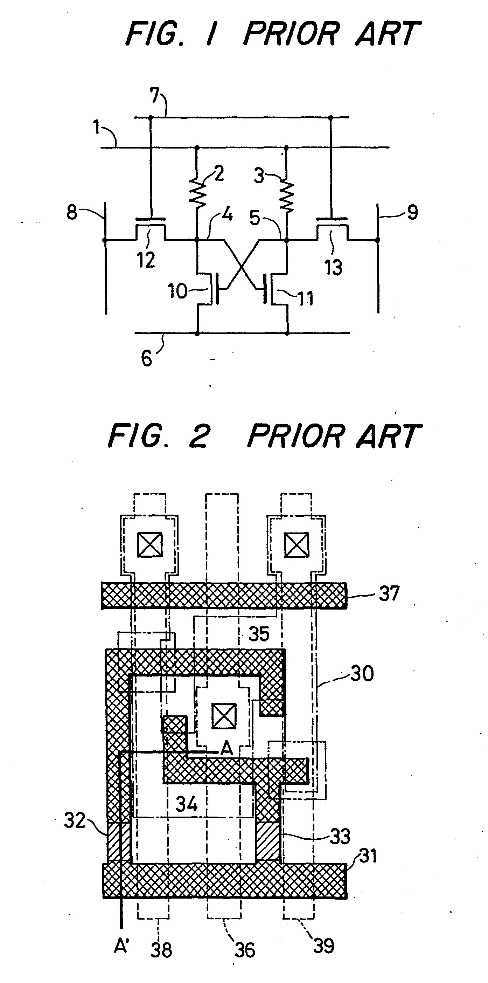

For example in a semiconductor memory, especially, in a static random access memory (which is abbreviated into an "S-RAM"), the resistors are used as the load. Fig. 1 shows one example of the S-RAM. In Fig. 1: reference numeral 1 indicates a power supply line (at a potential Vcc); numerals 2 and 3 are load resistors; numerals 4 and 5 are load storage nodes; numeral 6 is a ground line (at a potential Vss); numeral 7 is a word line; numerals 8 and 9 are data lines; numerals 10 and 11 are MOS transistors (which will be shortly referred to as "MOSTs") acting as driving transistors; and numerals 12 and 13 are transfer MOSTs. In the prior art, the power supply line 1 is made of a highly doped polycrystalline silicon region identical to that forming the gates of the MOSTs 10 to 13, and the load resistors 2 and 3 are formed by either leaving a portion of that polycrystalline silicon region as an intrinsic semiconductor region or making the same of a low doped region. In other words, the gate electrodes of the MOSTs 10 to 13, the power supply line 1 and the load resistors 2 and 3 are formed in a common plane.

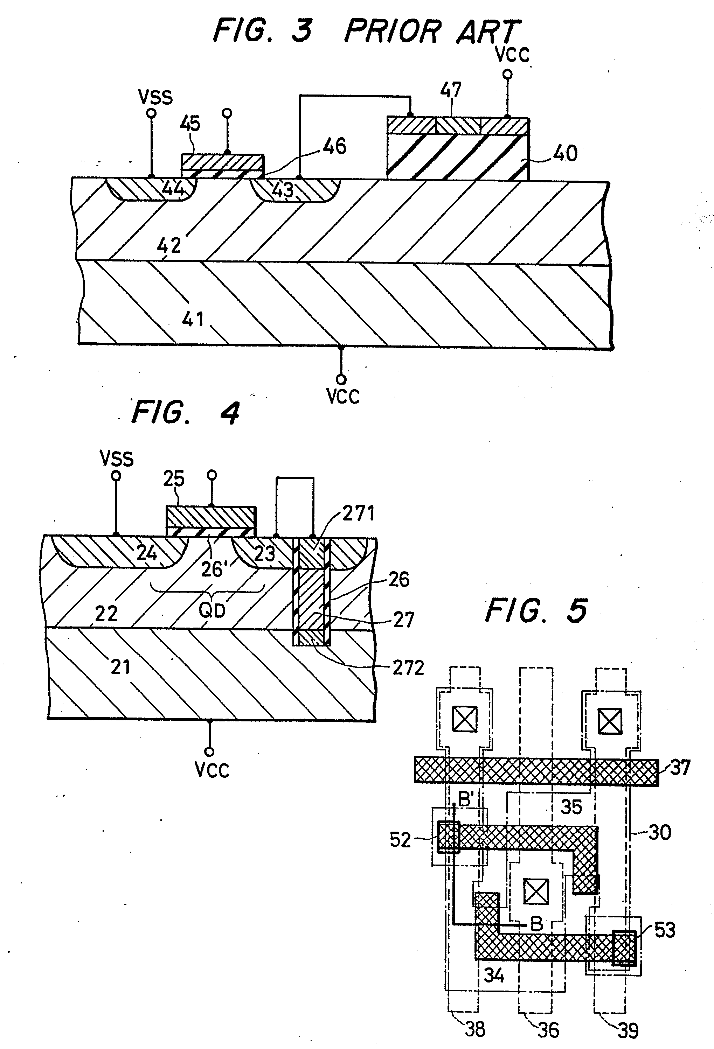

Fig. 2 shows one example of the plane pattern of the integrated circuit of Fig. 1. A region enclosed by single-dotted lines 30 provides the element region of a MOST, in which source and drain diffusion regions are formed across gates 31 and 37. Moreover, reference numeral 31 indicates a power supply line; numerals 32 and 33 are load resistors; numerals 34 and 35 are charge storage nodes; numeral 36 is a ground line; numeral 37 is a word line; and numerals 38 and 39 are data lines. A schematic section taken along line A - A' is shown in Fig. 3. A p-type well region 42 formed on a semiconductor substrate of n-type conductivity 41 is formed on its surface portion with a MOST which is composed of highly doped drain and source regions of n-type conductivity 43 and 44 and a polycrystalline silicon gate electrode 45. Reference numeral 46 in Fig. 3 indicates a gate insulating film. On the other hand, the resistors 32 and 33 are formed by either leaving a portion of the polycrystalline silicon identical to the gate electrode as an intrinsic semiconductor on a thick insulator 40 or lowly doping the same with an impurity. Moreover, the drain region 43 is connected through a load resistor 47 with the power supply line. In this example, the gate electrode of the MOST, the power supply line and the load resistor are formed in the common plane because of the pattern construction.

As a result, the semiconductor integrated circuit of the prior art has a defect that it cannot effect sufficiently high integration.

SUMMARY OF THE INVENTION

An object of the present invention is to provide a semiconductor device which can effect sufficiently high integration while eliminating the defect described in the above.

At present, the technique of forming the surface of a substrate with a deep hole having a small area is reported as a technique for forming a semiconductor element isolation region.  By applying this technique, the present invention contemplates a semiconductor integrated circuit by forming such a resistor of small area in the direction of deep of a semiconductor substrate as has its one end connected with a power supply.

BRIEF DESCRIPTION OF THE DRAWINGS

Fig. 1 is a circuit diagram showing a static type semiconductor memory cell having a high resistor as a load;

Fig. 2 shows one example of a plane pattern of the integrated circuit of the circuit of Fig. 1;

Fig. 3 is a section taken along line A - A' of Fig. 2;

Fig. 4 is a section showing an embodiment of the semiconductor device of the present invention;

Fig. 5 shows one example of the plane pattern of the integrated circuit of the static type semiconductor memory cell formed according to the present invention;  and

Figs. 6A to 6F are sectional views showing the consecutive steps of a process for fabricating the semiconductor device of Fig. 4.

DESCRIPTION OF THE PREFERRED EMBODIMENT

The present invention will be described in the following in connection with one embodiment thereof with reference to Fig. 4. In Fig. 4, a well region of p-type conductivity 22 lying on a highly doped semiconductor substrate of n-type conductivity 21 made of Si or the like is formed in its surface portion with a MOST $Q_D$ which is composed of drain and source regions 23 and 24 of n-type conductivity and a gate electrode 25 of polycrystalline silicon. Reference numeral 26' in Fig. 4 indicates a gate insulating film. Between the drain region 23 of the MOST $Q_D$ and the substrate 21 taking the potential of a power supply, there is formed a resistor 27 which is made of a substance such as polycrystalline silicon and which is isolated from the p-type well region 22 by an insulator 26 such as an oxide film. As shown, the gate electrode 25 and the upper portion 271 of the polycrystalline silicon acting as the resistor are made into the n-type regions by the impurities which are introduced while the drain and source regions are being formed, and the polycrystalline silicon region 272 located in the lower portion of the resistor is made into the n-type region by the impurities which will migrate up from the highly doped substrate so that either the ohmic contact with metal electrodes and so on or the connection

- 6 -

with the substrate can be made. Here, if the substrate 21 and the source of the MOST $Q_D$ are held at the potentials Vcc and Vss, respectively, the resistor 27 and the MOST $Q_D$ provide the elements corresponding to the elements 2 and 10 of Fig. 1 so that an inverter is constituted. As a result, the static memory cell shown in Fig. 1 can be made by additionally providing a pair of similar inverters to constitute a flip-flop circuit inbetween and by further providing an information transfer transistor.

Fig. 5 shows one example of the plane pattern in which the example of Fig. 1 is constructed according to the present invention. Reference numerals 52 and 53 indicate resistor portions which are connected with the highly doped substrate at the power supply potential. The section taken along line B - B' of Fig. 5 is shown in Fig. 4. As is apparent from the comparison of these two Figures, the effect that the memory cell can be highly integrated can be obtained according to the present invention from the facts that the load resistors formed on the semiconductor surface according to the prior art can be formed in the direction of the depth of the substrate and that it becomes unnecessary to provide the power supply line which is arranged on the substrate surface through the memory cells.

In the example of Fig. 4, the deep hole having the resistor 27 formed therein is formed in the drain region 23. However, it should be noted that hole may be formed either outside of the drain region 23 or in the boundary between the drain region 23 and the well 22.

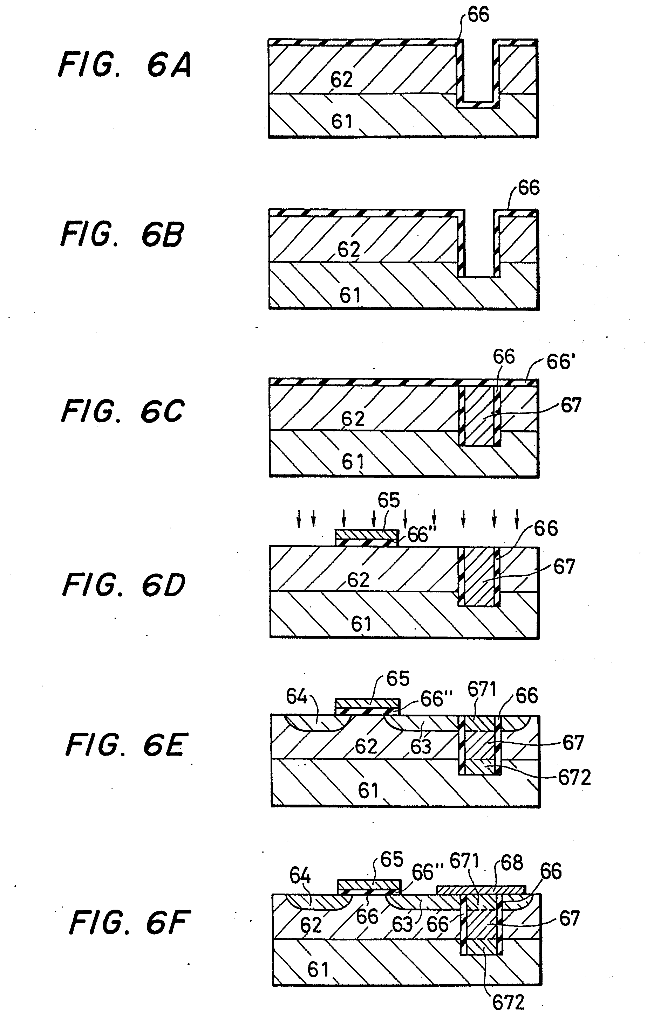

Figs. 6A to 6F are sectional views showing the consecutive steps of the process for fabricating the semiconductor integrated circuit of the present invention.

A p-type well region 62 (which has an impurity concentration of $10^{16}$ cm$^{-3}$ and a depth of 3 to 4 μm) is formed on an n-type highly doped Si substrate 61 (which has an impurity concentration of $10^{20}$ cm$^{-3}$), and there is formed a hole which extends from the surface of said well to the substrate. After that, a thin insulating film 66 (which is made of $SiO_2$ or $Si_3N_4/SiO_2$ having a thickness of 0.1 μm) is formed all over the surface. (Reference should be made to Fig. 6A.)

The insulating film is selectively removed only from the bottom of the hole by the unisotropic etching technique or the like. (Reference should be made to Fig. 6B.)

- 8 -

Next, intrinsic polycrystalline Si is deposited all over the substrate so that it is buried in the hole. The polycrystalline Si on the substrate surface is then removed while the polycrystalline Si being left in the hole, and the insulating film 66 is removed from the whole surface. An insulating film 66' (which is made of $SiO_2$ having a thickness larger than 10 nm) for forming the gate insulating film is formed again all over the surface. (Reference should be made to Fig. 6C.)

Next, polycrystalline Si for forming the gate electrode is deposited, and gate portions 65 and 66" are formed by the etching technique. An n-type impurity is then introduced into the drain and source regions of the MOST by the ion-implantation technique (with an implantation more than $10^{13}$ $cm^{-2}$). (Reference should be made to Fig. 6D.)

Next, drain and source regions 63 and 64 are formed by the thermal diffusion technique. (Reference should be made to Fig. 6E.)

At this time, the polycrystalline silicon 67 buried in the hole has its upper region 671 and lower region 672 made into the n-type regions by the impurity implanted and by the impurity diffusing from the substrate, respectively.

Next, by forming a metal wiring 68 of Aℓ or the like, the drain region 63 of the MOST is connected through the resistor 67 with the substrate 61 thereby to make the construction shown in Fig. 4. (Reference should be made to Fig. 6F.)

In the foregoing embodiment, the description is made by taking up the n-channel type MOST as an example. Despite of this fact, the present invention can be realized even if a p-channel MOST is used by inverting the n- and p-types.

Moreover, the wells 22 and 62 may be semiconductor epitaxial growth regions of opposite type conductivity to that of the substrate, which is formed on the substrates 21 and 61.

In the embodiment thus far described, still moreover, the construction of the semiconductor integrated circuit of the present invention is applied to the S-RAM. It is, however, quite natural that the present invention can be applied to another circuit.

WHAT IS CLAIMED IS:

1.    A semiconductor integrated circuit comprising a semiconductor substrate (21; 61) of a first type conductivity; a semiconductor region (22; 62) of a second type conductivity formed on said substrate (21; 61); and a resistor (27; 67) made of a semiconductor region; characterised in that said resistor (27; 67) is formed through an insulating film (26; 66) in a hole which is formed in the depth direction from the surface region of said semiconductor region (22; 62) of the second type conductivity to said semiconductor substrate (21; 61), the lower end of said resistor (27; 67) being connected with said semiconductor substrate (21; 61).

2.    The circuit of claim 1, characterised in that said resistor (27; 67) has its upper and lower ends formed with highly doped regions (271, 272; 671; 672).

3.    The circuit of claim 2, characterised in that said semiconductor region (22; 62) of the second type conductivity is formed with an insulated gate type transistor (Q$_D$) having source and drain regions (24, 23; 64, 63) of the first type conductivity, at least one (23; 63) of which is formed with said hole having said resistor (27; 67) formed therein and is connected with the upper end of said resistor (27; 67).

4.    The circuit of any of claims 1 to 3, characterised in that said insulated gate type transistor (Q$_D$) and said resistor (27; 67) constitute together the inverter portion of a flip-flop circuit, and wherein said substrate (21; 61) is connected with a power supply ($V_{CC}$).

5.    The circuit of claim 4, characterised by a transfer transistor connected with the charge storage node of said flip-flop circuit thereby to constitute a static random access memory cell together with said flip-flop circuit.

6.    The circuit of any of claims 1 to 5, characterised in that said semiconductor region (22; 62) of the second type conductivity is a well diffusion region formed on said substrate (21; 61) surface region.

7.    The circuit of any of claims 1 to 5, characterised in that said semiconductor region (22; 62) of the second type conductivity is a semiconductor epitaxial growth region formed on said substrate (21; 61).

8.    The circuit of any of claims 1 to 7, characterised in that the semiconductor region making said resistor (27; 67) is an intrinsic or lowly doped polycrystalline semiconductor.

## FIG. 1  PRIOR ART

## FIG. 2  PRIOR ART

## FIG. 3 PRIOR ART

VSS

VCC

45

47

46

40

44

43

42

41

VCC

## FIG. 4

VSS

25

271

24

26'

23

26

22

27

QD

272

21

VCC

## FIG. 5

37

B'

35

52

30

B

53

34

38

36

39

**FIG. 6A**

66
62
61

**FIG. 6B**

66
62
61

**FIG. 6C**

66 66'
62 67
61

**FIG. 6D**

65
66"
66
62 67
61

**FIG. 6E**

64 65 66" 671 66
62 63 67
61 672

**FIG. 6F**

64 65 66" 671 68 66
62 66 63 66 67
61
672